(19) **Europäisches Patentamt / European Patent Office / Office européen des brevets**

(11) **EP 4 668 363 A1**

(12) **EUROPEAN PATENT APPLICATION**
published in accordance with Art. 153(4) EPC

(43) Date of publication:
**24.12.2025 Bulletin 2025/52**

(21) Application number: **24815918.8**

(22) Date of filing: **31.05.2024**

(51) International Patent Classification (IPC):
**H01M 4/525** (2010.01)   **C30B 29/22** (2006.01)
**H01M 4/02** (2006.01)

(52) Cooperative Patent Classification (CPC):
Y02E 60/10

(86) International application number:
**PCT/KR2024/007495**

(87) International publication number:
**WO 2024/248544 (05.12.2024 Gazette 2024/49)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **02.06.2023 KR 20230071877**

(71) Applicant: **LG Chem, Ltd.**
**Seoul 07336 (KR)**

(72) Inventors:
• **PARK, Hyun Ah**
**Daejeon 34122 (KR)**
• **JUNG, Won Sig**
**Daejeon 34122 (KR)**
• **JEONG, Jong Seok**
**Daejeon 34122 (KR)**
• **KIM, Jong Pil**
**Daejeon 34122 (KR)**
• **PARK, Jung Won**
**Daejeon 34122 (KR)**

(74) Representative: **Hoffmann Eitle**
**Patent- und Rechtsanwälte PartmbB**
**Arabellastraße 30**
**81925 München (DE)**

(54) **POSITIVE ELECTRODE ACTIVE MATERIAL, AND POSITIVE ELECTRODE AND LITHIUM SECONDARY BATTERY COMPRISING SAME**

(57)   The present invention relates to a positive electrode active material including a lithium transition metal oxide in a form of a single particle, and a positive electrode and a lithium secondary battery which include the same, and to a single particle type positive electrode active material, wherein the lithium transition metal oxide in the form of a single particle includes an outer boundary forming an outline of the particle and an inner boundary formed in the particle, and satisfies that 0 < length of the inner boundary/length of the outer boundary < 0.4.

[FIG. 1]

SEM   EBSD Band Contrast   Band Contrast Boundary

EBSD IPF   IPF Total Boundary

EP 4 668 363 A1

## Description

### TECHNICAL FIELD

Cross-reference to Related Applications

This application claims priority from Korean Patent Application No. 10-2023-0071877, filed on June 2, 2023, the disclosure of which is incorporated by reference herein.

Technical Field

The present invention relates to a positive electrode active material for a lithium secondary battery, and a positive electrode and a lithium secondary battery which include the same.

### BACKGROUND ART

With the recent technological development of electric vehicles, demand for high-capacity secondary batteries is increasing, and, accordingly, research on a positive electrode using a high nickel (high Ni) positive electrode active material with excellent capacity characteristics is being actively conducted.

Since co-precipitation is used to prepare the high nickel positive electrode active material, the prepared high nickel positive electrode active material has a form of a secondary particle in which primary particles are aggregated. However, the active material in the form of a secondary particle causes a side reaction due to microcracks generated in the secondary particle during a long-term charge and discharge process, and also, in a case in which electrode density is increased to improve energy density, the secondary particle is disadvantageous in that structural collapse of the secondary particle occurs to cause a degradation in life characteristics and a decrease in energy density due to a decrease in the active material and an electrolyte solution.

In order to solve such problems of the high nickel positive electrode active material in the form of a secondary particle, a single crystal type nickel-based positive electrode active material has recently been developed. The single crystal type nickel-based positive electrode active material has an advantage in that particles do not collapse even in the case that the electrode density is increased for high energy density. However, since a relatively high sintering temperature is required to prepare the single crystal type nickel-based positive electrode active material, a phase change into an Fm-3m rock-salt structure, such as NiO, occurs as an R-3m layered structure is not properly maintained and lithium escapes from the crystal structure and a ratio of NiO on a surface portion of the prepared single crystal type particle is increased as crystallinity of the positive electrode active material is reduced, and thus, there is a problem in that resistance increases as the NiO increases, and a decrease in energy density and output occurs. Also, in a case in which the sintering temperature is decreased, since it exists in the form of an over-sintered secondary particle, there is a problem in that an effect of improving lifetime and gas generation does not reach a level expected from the single particle.

Thus, there is still a need to develop a positive electrode active material exhibiting excellent life characteristics and output characteristics while having high electrode density.

[Prior Art Documents]

[Patent Documents]

(Patent Document 1) KR 2019-0094529 A1

### DISCLOSURE OF THE INVENTION

### TECHNICAL PROBLEM

An aspect of the present invention provides a positive electrode active material having excellent life characteristics.

### TECHNICAL SOLUTION

In order to solve the above-described tasks, the present invention provides a positive electrode active material, a positive electrode, and a lithium secondary battery.

(1) The present invention provides a positive electrode active material including a lithium transition metal oxide in a form of a single particle, wherein the lithium transition metal oxide in the form of a single particle includes an outer boundary forming an outline of the particle and an inner boundary formed in the particle, and satisfies Equation 1, 0 < length of the inner boundary/length of the outer boundary < 0.4     [Equation 1]

The length of the inner boundary is a length obtained by subtracting a length of a boundary, which is measured from an EBSD band contrast map, from a length of a boundary which is measured from an electron backscatter diffraction (EBSD)-inverse pole figure (IPF) map of the lithium transition metal oxide particle, and the length of the outer boundary is a length of the outer boundary of the transition metal oxide particle which is measured by scanning electron microscope (SEM) image segmentation.

(2) The present invention provides the positive electrode active material of (1) above, wherein the lithium transition metal oxide in the form of a single particle additionally satisfies Equation 2.

The length of the boundary which is measured from the EBSD IPF map/the length of the boundary which is measured from the EBSD band contrast map $\leq$ 1.4     [Equation 2]

The length of the outer boundary is the length of the outer boundary of the transition metal oxide particle which is measured by the SEM image segmentation.

(3) The present invention provides the positive electrode active material of (1) or (2) above, wherein the lithium transition metal oxide in the form of a single particle additionally satisfies Equation 3.

$0 \leq$ (the length of the inner boundary/the length of the outer boundary) - (the length of the inner boundary/the length of the boundary which is measured from the EBSD band contrast map) $\leq 1$     [Equation 3]

(4) The present invention provides the positive electrode active material of any one of (1) to (3) above, wherein the length of the boundary, which is measured from the electron backscatter diffraction (EBSD)-IPF map, includes a length of a weak boundary, where an atomic arrangement is simply different and crystallinity is not collapsed, which is included in the lithium transition metal oxide particle in the form of a single particle, and a length of a strong boundary formed by collapse of a layered structure.

(5) The present invention provides the positive electrode active material of any one of (1) to (4) above, wherein the length of the boundary, which is measured by the EBSD band contrast map, includes a length of a strong boundary formed by collapse of a layered structure which is included in the lithium transition metal oxide particle in the form of a single particle.

(6) The present invention provides the positive electrode active material of any one of (1) to (5) above, wherein the lithium transition metal oxide in the form of a single particle includes 2 to 50 particles.

(7) The present invention provides the positive electrode active material of any one of (1) to (6) above, wherein the lithium transition metal oxide is a lithium composite transition metal oxide containing nickel, cobalt, and manganese.

(8) The present invention provides the positive electrode active material of any one of (1) to (7) above, wherein the lithium transition metal oxide is a lithium composite transition metal oxide represented by Formula 1:

[Formula 1]      $Li_aNi_bCo_cMn_dM^1_eO_2$

In Formula 1, $M^1$ is at least one selected from the group consisting of aluminum (Al), zirconium (Zr), boron (B), tungsten (W), molybdenum (Mo), chromium (Cr), niobium (Nb), magnesium (Mg), hafnium (Hf), tantalum (Ta), lanthanum (La), titanium (Ti), strontium (Sr), barium (Ba), cerium (Ce), tin (Sn), yttrium (Y), zinc (Zn), fluorine (F), phosphorus (P), and sulfur (S), and $0.9 \leq a \leq 1.1$, $0.6 \leq b < 1$, $0 < c < 0.4$, $0 < d < 0.4$, $0 \leq e < 0.1$, and $b+c+d+e=1$.

(9) The present invention provides the positive electrode active material of any one of (1) to (8) above, wherein the lithium transition metal oxide is a lithium composite transition metal oxide represented by Formula 2:

[Formula 2]      $Li_aNi_bCo_cMn_dO_2$

In Formula 2, $0.9 \leq a \leq 1.1$, $0.6 \leq b < 1$, $0 < c < 0.4$, $0 < d < 0.4$, and $b+c+d=1$.

(10) The present invention provides the positive electrode active material of any one of (1) to (9) above, wherein the positive electrode active material further includes a second lithium transition metal oxide in a form of a single particle, which has a smaller average particle diameter ($D_{50}$) than the lithium transition metal oxide in the form of a single particle, and has a bimodal particle size distribution.

(11) The present invention provides the positive electrode active material of (10) above, wherein the second lithium transition metal oxide is a lithium composite transition metal oxide represented by Formula 3.

$$[\text{Formula 3}] \qquad Li_{a3}Ni_{b3}Co_{c3}Mn_{d3}M^3_{e3}O_2$$

In Formula 3, $M^3$ is at least one selected from the group consisting of Al, Zr, B, W, Mo, Cr, Nb, Mg, Hf, Ta, La, Ti, Sr, Ba, Ce, Sn, Y, Zn, F, P, and S, and $0.9 \leq a3 \leq 1.1$, $0.6 \leq b3 < 1$, $0 < c3 < 0.4$, $0 < d3 < 0.4$, $0 \leq e3 < 0.1$, and $b3+c3+d3+e3=1$.

(12) The present invention provides the positive electrode active material of (10) or (11) above, wherein a weight ratio of the lithium transition metal oxide to the second lithium transition metal oxide is in a range of 1~9:1.

(13) The present invention provides the positive electrode active material of any one of (10) to (12) above, wherein press density is in a range of $3.50 \text{ g/cm}^2$ to $3.90 \text{ g/cm}^2$.

(14) The present invention provides a positive electrode including the positive electrode active material of any one of (1) to (13) above.

(15) The present invention provides a lithium secondary battery including the positive electrode of (14) above.

## ADVANTAGEOUS EFFECTS

A positive electrode active material of the present invention is a positive electrode active material including a lithium transition metal oxide in a form of a single particle, wherein, since the lithium transition metal oxide in the form of a single particle includes a certain amount of an inner boundary, excellent life characteristics may be exhibited.

## BRIEF DESCRIPTION OF THE DRAWINGS

FIG. 1 is a scanning electron microscope (SEM) image, an electron backscatter diffraction (EBSD) band contrast map, an EBSD-inverse pore figure (IPF) map, and an IPF boundary of a positive electrode active material of Example 1.

FIG. 2 is an SEM image, an EBSD band contrast map, an EBSD-IPF map, and an IPF boundary of a positive electrode active material of Comparative Example 4.

## BEST MODE FOR CARRYING OUT THE INVENTION

Hereinafter, the present invention will be described in more detail to allow for a clearer understanding of the present invention.

It will be understood that words or terms used in the specification and claims shall not be interpreted as the meaning defined in commonly used dictionaries, and it will be further understood that the words or terms should be interpreted as having a meaning that is consistent with their meaning in the context of the relevant art and the technical idea of the invention, based on the principle that an inventor may properly define the meaning of the words or terms to best explain the invention.

In the present invention, the expression 'primary particle' denotes a smallest particle unit which is distinguished as one body when a cross section of a positive electrode active material is observed through a scanning electron microscope (SEM), wherein it may be composed of a plurality of grains.

In the present invention, the expression 'secondary particle' denotes a secondary structure formed by aggregation of a plurality of primary particles. An average particle diameter of the secondary particle may be measured using a particle size analyzer.

The expression 'a form of a single particle' in the present invention may be used interchangeably with the expression 'single crystallinity' or 'single particle type', and means a form in contrast to a form of a secondary particle which is formed by aggregation of hundreds of primary particles that are prepared by a conventional method. Also, the expression 'single particle type positive electrode active material' or 'lithium transition metal oxide in a form of a single particle' in the present invention is a concept in contrast to a positive electrode active material in a form of a secondary particle which is formed by aggregation of hundreds of primary particles that are prepared by a conventional method, wherein it means a positive electrode active material or lithium transition metal active material which is composed of 50 or less single crystal particles.

Typically, a single crystal particle refers to a particle in which an entire sample is composed of only one grain or grain region. The single particle type positive electrode active material or the lithium transition metal oxide in the form of a single particle in the present invention is a single particle type positive electrode active material or lithium transition metal oxide in the form of a single particle in which 1 to 50 particles, specifically, 1 to 30 particles are aggregated, wherein it may exhibit characteristics similar to those of one single crystal particle by including a small number of single crystal particles. The 'single crystal particle' denotes the smallest unit of particles recognized when a positive electrode active material is observed through a scanning electron microscope, and the 'grain' or 'grain region' means a region in which atoms in the sample are continuously and periodically arranged in one direction. The grain may be analyzed by obtaining an EBSD IPF (inverse pole figure) map using an electron backscatter diffraction (EBSD) analyzer.

The expression 'average particle diameter ($D_{50}$)' in the present invention denotes a particle diameter at 50% of cumulative distribution of volume according to the particle diameter. After dispersing measurement target powder in a dispersion medium, the dispersion medium is introduced into a commercial laser diffraction particle size measurement instrument (e.g., Microtrac S3500), a particle size distribution is calculated by measuring a difference in diffraction patterns due to a particle size when particles pass through a laser beam, and the $D_{50}$ may be measured by calculating a particle diameter at 50% of the cumulative distribution of volume according to the particle diameter using the measurement instrument.

A positive electrode active material of the present invention is a positive electrode active material including a lithium transition metal oxide in a form of a single particle, wherein the lithium transition metal oxide in the form of a single particle includes an outer boundary forming an outline of the particle and an inner boundary formed in the particle, and satisfies Equation 1 below.

$$0 < \text{length of the inner boundary/length of the outer boundary} < 0.4 \qquad \text{[Equation 1]}$$

The length of the inner boundary is a length obtained by subtracting a length of a boundary, which is measured from an EBSD band contrast (BC) map, from a length of a boundary which is measured from an electron backscatter diffraction (EBSD)-inverse pole figure (IPF) map of the lithium transition metal oxide particle, and the length of the outer boundary is a length of the outer boundary of the transition metal oxide particle which is measured by SEM image segmentation.

The inner boundary in the present invention may mean a boundary formed by grains, which are included in the lithium transition metal oxide particle in the form of a single particle, in contact with each other. Since lithium ions easily move at the inner boundary which means the boundary formed by the grains in contact with each other, degradation occurs preferentially as charge/discharge cycles proceed and life characteristics may be degraded as there are many movement paths through which the lithium ions easily move. An amount of the inner boundary may be quantitatively determined by the length of the inner boundary included in the lithium transition metal oxide particle in the form of a single particle.

If an EBSD IPF map is obtained for the lithium transition metal oxide particle in the form of a single particle using an EBSD IPF measurement method, it is possible to distinguish the grains included in the lithium transition metal oxide particle in the form of a single particle. Thus, from the EBSD IPF map, it is possible to identify a boundary formed by one grain, which is included in the lithium transition metal oxide particle in the form of a single particle, in contact with another grain.

However, the boundaries identified by the EBSD IPF map not only include a boundary (weak boundary) between grains where an arrangement direction of atoms simply changes based on the boundary, but also include a boundary (strong boundary) where there is a collapse of a layered structure of a transition metal oxide layer, particularly, a collapse of a layered structure of a NiO layer, along with the change in the arrangement direction of the atoms. Thus, in order to obtain only the boundary between the grains, it is necessary to exclude the boundary where the layered structure of the transition metal oxide layer is collapsed.

If a BC map is obtained for the lithium transition metal oxide particle in the form of a single particle by EBSD, the weak boundary included in the lithium transition metal oxide particle in the form of a single particle, where only the atomic arrangement is simply different and crystallinity is not collapsed, is not distinguished, but the strong boundary, where the layered structure of the transition metal oxide is collapsed, may be distinguished. The boundary, where the layered structure of the transition metal oxide is collapsed, may be a boundary formed between one single crystal particle included in the lithium transition metal oxide particle in the form of a single particle and another single crystal particle.

The length of the boundary, which is measured from the EBSD IPF map, may include lengths of the boundary between the grains included in the lithium transition metal oxide particle in the form of a single particle, the boundary formed by the collapse of the layered structure, and the outer boundary of the particle.

Also, the length of the boundary, which is measured from the EBSD BC map, may include lengths of the outer boundary and the boundary formed by the collapse of the layered structure included in the lithium transition metal oxide particle in the form of a single particle.

Therefore, the length of the inner boundary is a length obtained by subtracting the length of the boundary, which is measured from the EBSD BC map, from the length of the boundary which is measured from the EBSD IPF map of the lithium transition metal oxide particle, and, since the length of the outline (outer boundary) of the lithium transition metal oxide particle in the form of a single particle is measured the same in the EBSD IPF map and the EBSD BC map, the length of the inner boundary may be expressed as follows when the length of the outer boundary is excluded.

```
Length of the inner boundary

= [length of the boundary which is measured from the EBSD IPF map] - [length of the boundary which is measured from the EBSD BC map]

= [length of the strong boundary + length of the weak

boundary] - [length of the strong boundary]

= length of the weak boundary
```

Also, with respect to the length of the outer boundary of the lithium transition metal oxide particle in the form of a single particle, an SEM image of the lithium transition metal oxide particle in the form of a single particle is obtained, and the length of the outer boundary forming an outer surface of the lithium transition metal oxide particle may be obtained by the SEM image segmentation.

Equation 1 above is a value obtained by dividing the length of the inner boundary by the length of the outer boundary, wherein it quantifies a degree of inclusion of the inner boundary of the lithium transition metal oxide particle in the form of a single particle.

A decrease in a value, which is obtained by dividing a length of line formed inside an object of a circular or similar shape, which is calculated through two-dimensional images obtained using EBSD and SEM, by a length of an outline of the object, may reflect a decrease in the length of the weak boundary inside the lithium transition metal oxide particle in the form of a single particle, and, with respect to the single particle type positive electrode active material of the present invention, the length of the inner boundary/the length of the outer boundary of Equation 1 is less than 0.4, wherein, since the single particle type positive electrode active material satisfies the above value, excellent life characteristics may be exhibited by reducing a phenomenon in which degradation occurs preferentially in the movement path through which the lithium ions easily move.

The value of the length of the inner boundary/the length of the outer boundary of Equation 1 may specifically satisfy greater than 0 and equal to or less than 0.3, more specifically, greater than 0.01 and equal to or less than 0.2. In a case in which the value of Equation 1 is excessively large, an effect of improving the life characteristics of the single particle type positive electrode active material may be reduced. In addition, in a case in which the value of Equation 1 is 0, an effect of improving the capacity characteristics and life characteristics of the single particle type positive electrode active material may be may be reduced.

Thus, in a case in which the lithium transition metal oxide particle in the form of a single particle of the present invention satisfies the value of Equation 1, a better effect of improving the life characteristics may be exhibited.

A degree of single-crystal formation of the lithium transition metal oxide particle in the form of a single particle may be determined through the value of Equation 1, and, for example, in a case in which the lithium transition metal oxide particle in the form of a single particle is a single crystal, the value of Equation 1 is 0, and, in a case in which the lithium transition metal oxide particle in the form of a single particle has a low degree of single-crystal formation by including a large amount of crystals, the value of Equation 1 is increased.

Also, the lithium transition metal oxide in the form of a single particle may additionally satisfy Equation 2 below.

Length of the boundary which is measured from the EBSD IPF map/length of the boundary which is measured from the EBSD band contrast map ≤ 1.4          [Equation 2]

Equation 2 is a value obtained by dividing a sum of the length of the strong boundary and the length of the weak boundary which are measured from the EBSD IPF map by the length of the strong boundary measured by the EBSD BC map.

The value of Equation 2 decreases as a ratio of the length of the weak boundary, where only the atomic arrangement is simply different and the crystallinity is not collapsed, among the boundaries of the lithium transition metal oxide in the form of a single particle decreases or a ratio of the strong boundary, which is formed by the collapse of the layered structure, increases in comparison to the weak boundary.

With respect to the positive electrode active material of the present invention, the length of the boundary which is measured from the EBSD IPF map/the length of the boundary which is measured from the EBSD band contrast map of Equation 2 may specifically satisfy a range of 1 to 1.4, more specifically, 1 to 1.3.

In a case in which the value of Equation 2 satisfies the above range, excellent life characteristics may be appropriately exhibited, and, in a case in which the value of Equation 2 is excessively large, the life characteristics of the positive electrode active material may be degraded.

Thus, in a case in which the value of Equation 2 satisfies the above range while the lithium transition metal oxide in the form of a single particle of the present invention satisfies the value of Equation 1, better life characteristics may be exhibited.

The length of the outer boundary is the length of the outer boundary of the transition metal oxide particle which is measured by the SEM image segmentation.

With respect to the length of the outer boundary of the lithium transition metal oxide particle in the form of a single particle, an SEM image of the lithium transition metal oxide particle in the form of a single particle is obtained, and the length of the outer boundary forming the outer surface of the lithium transition metal oxide particle may be obtained by the SEM image segmentation.

Also, the positive electrode active material of the present invention may satisfy Equation 3 below, which is a difference between the value of Equation 2 and the value of Equation 1.

$$0 \leq \text{(length of the inner boundary/length of the outer boundary)} - \text{(length of the inner boundary/length of the boundary which is measured from the EBSD band contrast map)} \leq 1 \qquad \text{[Equation 3]}$$

With respect to the positive electrode active material of the present invention, Equation 3 may specifically satisfy a range of 0 to 0.8, 0 to 0.7, or 0 to 0.5, more specifically, 0 to 0.3. In a case in which Equation 3 satisfies the above range, an appropriate capacity development effect may be exhibited while excellent life characteristics are exhibited.

In the positive electrode active material according to an embodiment of the present invention, the particles included in the positive electrode active material may have an average particle diameter ($D_{50}$) of 0.1 $\mu$m to 10 $\mu$m. In a case in which the average particle diameter of the particles included in the positive electrode active material satisfies the above range, when they are aggregated to form a single particle type positive electrode active material or lithium transition metal oxide in the form of a single particle, it may have an advantage in terms of rolling ratio or electrode pores, and, in a case in which the average particle diameter is less than or greater than the above range, performance in terms of electrode capacity, life characteristics, or resistance may be deteriorated.

In the positive electrode active material according to the embodiment of the present invention, the lithium transition metal oxide in the form of a single particle may be a lithium composite transition metal oxide containing nickel (Ni), cobalt (Co), and manganese (Mn).

Specifically, the lithium transition metal oxide in the form of a single particle may be a lithium composite transition metal oxide represented by Formula 1 below.

[Formula 1]   $Li_aNi_bCo_cMn_dM^1_eO_2$

In Formula 1, $M^1$ is at least one selected from the group consisting of aluminum (Al), boron (B), barium (Ba), cerium (Ce), chromium (Cr), fluorine (F), magnesium (Mg), vanadium (V), titanium (Ti), iron (Fe), zirconium (Zr), zinc (Zn), silicon (Si), yttrium (Y), niobium (Nb), gallium (Ga), tin (Sn), molybdenum (Mo), tungsten (W), phosphorus (P), sulfur (S), strontium (Sr), tantalum (Ta), lanthanum (La), and hafnium (Hf), and $0.9 \leq a \leq 1.1$, $0.6 \leq b < 1$, $0 < c < 0.4$, $0 < d < 0.4$, $0 \leq e < 0.1$, and $b+c+d+e=1$.

Also, specifically, the lithium transition metal oxide may be a positive electrode active material which is a lithium composite transition metal oxide represented by Formula 2 below.

[Formula 2]   $Li_aNi_bCo_cMn_dO_2$

In Formula 2, $0.9 \leq a \leq 1.1$, $0.6 \leq b < 1$, $0 < c < 0.4$, $0 < d < 0.4$, and $b+c+d=1$.

The positive electrode active material may have an average particle diameter ($D_{50}$) of 1 $\mu$m to 50 $\mu$m in consideration of specific surface area and positive electrode material mixture density, and may specifically have an average particle diameter ($D_{50}$) of 2 $\mu$m to 20 $\mu$m. In a case in which the average particle diameter of the positive electrode active material satisfies the above range, it may have an advantage in terms of rolling ratio or electrode pores, and, in a case in which the average particle diameter is less than or greater than the above range, performance in terms of electrode capacity, life characteristics, or resistance may be deteriorated.

In an embodiment of the present invention, the positive electrode active material may be composed of 2 to 50 particles, 2 to 40 particles, 2 to 30 particles, 2 to 20 particles, 2 to 15 particles, 2 to 10 particles, or 2 to 5 particles.

In an embodiment of the present invention, the lithium transition metal oxide particles in the form of a single particle may be prepared by mixing a transition metal oxide precursor with a lithium raw material and performing primary sintering, and disintegrating a pre-sintered product, which has been prepared by the primary sintering, and performing secondary sintering.

Specifically, the lithium transition metal oxide particles in the form of a single particle may be prepared by a method including steps of: (A) preparing a mixture by mixing a positive electrode active material precursor containing Ni, Co, and Mn with a first lithium-containing raw material; (B) preparing a primary sintered product by performing primary sintering on the mixture at a temperature of 800°C to 950°C; and (C) preparing a secondary sintered product by mixing a second lithium-containing raw material with the primary sintered product and performing secondary sintering at a temperature of 680°C to 850°C.

If the mixture is primarily sintered at a temperature of 800°C to 950°C, a primary sintered product in a form of a single particle is prepared while primary particles of the positive electrode active material precursor are aggregated. The primary sintering temperature may specifically be 800°C, 810°C, 820°C, 830°C, 840°C, 850°C or higher, 900°C, 910°C, 920°C, 930°C, 940°C, or 950°C or less. In a case in which the primary sintering temperature is within the above range, a structurally stable primary sintered product in the form of a single particle is prepared while the primary particles of the positive electrode active material precursor are aggregated, in a case in which the primary sintering temperature is less than 800°C, there is a problem in that the primary particles are not sufficiently aggregated, and, in a case in which the primary sintering temperature is greater than 950°C, there is a problem in that a structurally unstable sintered product with a low degree of crystallinity is prepared.

The primary sintering may be performed in an oxygen atmosphere, in terms of preventing degradation of the lithium transition metal oxide into a rock salt structure.

The primary sintering may be performed for 3 hours to 12 hours, specifically, 3 hours, 4 hours, 5 hours, 6 hours or more, 9 hours, 10 hours, 11 hours, or 12 hours or less, in terms of aggregating the primary particles and improving crystallinity of the primary sintered product.

If the primary sintered product is secondarily sintered at a temperature of 680°C to 850°C, a secondary sintered product is prepared while lithium is intercalated into the primary sintered product. In this case, the secondary sintered product is a lithium composite transition metal oxide in the form of a single particle. The secondary sintering temperature may specifically be 680°C, 700°C, 720°C, 740°C, 760°C, 780°C, 800°C or higher, 840°C, or 850°C or less. In a case in which the secondary sintering temperature is within the above range, there is an advantage in that the layered structure is restored while lithium is intercalated into the rock salt structure which may be formed on a surface of the primary sintered product due to the high temperature during the primary sintering and the lithium by-product is reduced. In a case in which the secondary sintering temperature is less than 680°C, there is a problem in that a lithium intercalation rate is low due to the low temperature, and, in a case in which the secondary sintering temperature is greater than 850°C, there is a problem in that the surface of the primary sintered product degrades into the rock salt structure due to the high temperature and the lithium by-product remains.

The secondary sintering may be performed in an oxygen atmosphere, in terms of preventing the degradation of the lithium transition metal oxide into the rock salt structure.

The secondary sintering may be performed for 3 hours to 12 hours, specifically, 3 hours, 4 hours, 5 hours, 6 hours, 9 hours or more, 9 hours, 10 hours, 11 hours, or 12 hours or less, in terms of increasing a degree of crystallinity of the internal crystal structure of the positive electrode active material.

Also, the method of preparing a positive electrode active material according to the present invention may further include a step of (B') grinding the primary sintered product, before step (C). The step (B') may grind the primary sintered product such that an average particle diameter ($D_{50}$) is in a range of 3 $\mu$m to 20 $\mu$m, in terms of preventing an increase in initial resistance.

Furthermore, the method of preparing a positive electrode active material according to the present invention may further include a step of (C') grinding the secondary sintered product. The step (C') may grind the secondary sintered product such that an average particle diameter ($D_{50}$) is in a range of 3 $\mu$m to 20 $\mu$m, in terms of also preventing the increase in initial resistance.

The grinding of step (B') and step (C') may be performed using a pin mill, an air classifying mill (ACM), or a jet mill. With respect to the pin mill, milling may be performed at 18,000 rpm, with respect to the ACM, classification may be performed at 6,000 rpm and main milling may be performed at 12,000 rpm using equipment by Hosokawa Micron Corporation, and, with respect to the jet mill, classification may be performed at 3,500 rpm and milling may be performed at a pressure of 6 bars using equipment by ZM solution. In this case, a positive electrode active material having a desired average particle diameter ($D_{50}$) may be easily obtained.

The positive electrode active material according to the present invention is prepared by a process of adding the lithium-containing raw material in two portions. That is, the lithium-containing raw material may be dividedly added before the primary sintering and before the secondary sintering. In this case, there is an advantage in that the intercalation of lithium into the rock salt structure, which may be formed on the surface, favors the restoration of the layered structure. In a case in which the lithium-containing raw material is added at once before the primary sintering, there is a problem of electrochemical performance degradation due to an increase in lithium by-product, and, if the lithium-containing raw material is not added in the secondary sintering, a problem occurs that requires high temperature and long time due to a low reaction rate.

In a case in which the lithium-containing raw material is added in two portions, in step (A), the first lithium-containing raw material may be mixed such that a ratio (M:Li) of the total number of moles (M) of transition metals included in the positive electrode active material precursor to the number of moles (Li) of lithium included in the first lithium-containing raw material is 1:0.98, 1:0.99, 1:1.00, 1:1.01, 1:1.02 or more, 1:1.04, or 1:1.05 or less, and, in step (C), the second lithium-containing raw material may be mixed such that a ratio (M:Li) of the total number of moles (M) of the transition metals included in the positive electrode active material precursor of step (A) to the number of moles (Li) of lithium included in the second lithium-containing raw material is 1:0.01 or more, 1:0.05, 1:0.06, 1:0.07, 1:0.08, 1:0.09, or 1:1.10 or less.

Also, the present invention provides a positive electrode active material further including a second lithium transition metal oxide in a form of a single particle, which has a smaller average particle diameter ($D_{50}$) than the lithium transition metal oxide in the form of a single particle (hereinafter, first lithium transition metal oxide), and having a bimodal particle size distribution.

Since the positive electrode active material having a bimodal particle size distribution includes two types of lithium transition metal oxides of different sizes, the second lithium transition metal oxide is filled between the first lithium transition metal oxide, and thus, press density is high such that a desired electrode thickness may be achieved without application of high pressure. Also, during rolling for electrode preparation, since stress applied to the first lithium transition metal oxide is distributed, particle cracking may be prevented.

In a case in which the positive electrode active material according to the present invention has a bimodal particle size distribution, the first lithium transition metal oxide may have an average particle diameter ($D_{50}$) of 5 μm to 9 μm. Specifically, the average particle diameter ($D_{50}$) of the first lithium transition metal oxide may be 5 μm, 5.5 μm, 6 μm, 6.5 μm or more, 7.5 μm, 8 μm, 8.5 μm, or 9 μm or less. In addition, the second lithium transition metal oxide may have an average particle diameter ($D_{50}$) of 1 μm to 4 μm. Specifically, the average particle diameter ($D_{50}$) of the second lithium transition metal oxide may be 1 μm, 1.5 μm, 2 μm, 2.5 μm or more, 2.5 μm, 3 μm, 3.5 μm, or 4 μm or less.

In a case in which the average particle diameters ($D_{50}$) of the first lithium transition metal oxide and the second lithium transition metal oxide are within the above ranges, since the second lithium transition metal oxide is appropriately distributed between the first lithium transition metal oxide, a packing ratio may be excellent.

A ratio of the average particle diameter of the first lithium transition metal oxide to the average particle diameter of the second lithium transition metal oxide may be in a range of 2:1 to 5:1. In a case in which the ratio of the average particle diameter of the first lithium transition metal oxide to the average particle diameter of the second lithium transition metal oxide is within the above range, the packing ratio is not only excellent, but also there is an advantage in that the press density is improved.

According to the present invention, the second lithium transition metal oxide may be a lithium composite transition metal oxide represented by Formula 3 below.

$$[\text{Formula 3}] \qquad Li_{a3}Ni_{b3}Co_{c3}Mn_{d3}M^3{}_{e3}O_2$$

In Formula 3, $M^3$ is at least one selected from the group consisting of Al, Zr, B, W, Mo, Cr, Nb, Mg, Hf, Ta, La, Ti, Sr, Ba, Ce, Sn, Y, Zn, F, P, and S, and $0.9 \leq a3 \leq 1.1$, $0.6 \leq b3 < 1$, $0 < c3 < 0.4$, $0 < d3 < 0.4$, $0 \leq e3 < 0.1$, and $b3+c3+d3+e3=1$.

According to the present invention, a weight ratio of the first lithium transition metal oxide to the second lithium transition metal oxide may be in a range of 1~9:1. In a case in which the weight ratio of the first lithium transition metal oxide to the second lithium transition metal oxide is within the above range, packing density of the particles may be increased, and, as a result, capacity of a battery may be increased when the positive electrode active material is used in the battery.

In the case that the positive electrode active material according to the present invention has a bimodal particle size distribution, the positive electrode active material may have a press density of 3.50 g/cm$^2$ to 3.90 g/cm$^2$. Specifically, the press density of the positive electrode active material may be 3.50 g/cm$^2$, 3.55 g/cm$^2$, 3.60 g/cm$^2$ or more, 3.80 g/cm$^2$, 3.85 g/cm$^2$, or 3.90 g/cm$^2$ or less. In a case in which the press density of the positive electrode active material is within the above range, energy density per volume may be increased.

**Positive Electrode**

According to another embodiment of the present invention, a positive electrode including the above-described positive electrode active material is provided.

Specifically, the positive electrode includes a positive electrode collector and a positive electrode active material layer which is formed on the positive electrode collector and includes the above-described positive electrode active material.

The positive electrode collector is not particularly limited as long as it has conductivity without causing adverse chemical changes in the battery, and, for example, stainless steel, aluminum, nickel, titanium, fired carbon, or aluminum or stainless steel that is surface-treated with one of carbon, nickel, titanium, silver, or the like may be used. Also, the positive electrode collector may typically have a thickness of 3 μm to 500 μm, and microscopic irregularities may be formed on the surface of the collector to improve the adhesion of the positive electrode active material. The positive electrode collector, for example, may be used in various shapes such as that of a film, a sheet, a foil, a net, a porous body, a foam body, a non-woven fabric body, and the like.

The positive electrode active material layer may include a conductive agent and a binder in addition to the above-described positive electrode active material.

In this case, the conductive agent is used to provide conductivity to the electrode, wherein any conductive agent may be used without particular limitation as long as it has suitable electron conductivity without causing adverse chemical changes in the battery. Specific examples of the conductive agent may be graphite such as natural graphite or artificial graphite; carbon based materials such as carbon black, acetylene black, Ketjen black, channel black, furnace black, lamp black, thermal black, and carbon fibers; powder or fibers of metal such as copper, nickel, aluminum, and silver; conductive whiskers such as zinc oxide whiskers and potassium titanate whiskers; conductive metal oxides such as titanium oxide; or conductive polymers such as polyphenylene derivatives, and any one thereof or a mixture of two or more thereof may be used. The conductive agent may be typically included in an amount of 1 wt% to 30 wt% based on the total weight of the positive electrode active material layer.

The binder improves the adhesion between the positive electrode active material particles and the adhesion between the positive electrode active material and the current collector. Specific examples of the binder may be polyvinylidene fluoride (PVDF), polyvinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, tetrafluoroethylene, polyethylene, polypropylene, an ethylene-propylene-diene monomer (EPDM), a sulfonated EPDM, a styrene-butadiene rubber (SBR), a fluorine rubber, or various copolymers thereof, and any one thereof or a mixture of two or more thereof may be used. The binder may be included in an amount of 1 wt% to 30 wt% based on the total weight of the positive electrode active material layer.

The positive electrode may be prepared according to a typical method of preparing a positive electrode except that the above-described positive electrode active material is used. Specifically, a composition for forming a positive electrode active material layer, which is prepared by dissolving or dispersing the above-described positive electrode active material as well as optionally the binder and the conductive agent in a solvent, is applied onto the positive electrode collector, and the positive electrode may then be prepared by drying and rolling the coated positive electrode collector. In this case, types and amounts of the positive electrode material, the binder, and the conductive agent are the same as those previously described.

The solvent may be a solvent normally used in the art. The solvent may include dimethyl sulfoxide (DMSO), isopropyl alcohol, N-methylpyrrolidone (NMP), acetone, or water, and any one thereof or a mixture of two or more thereof may be used. An amount of the solvent used may be sufficient if the solvent may dissolve or disperse the positive electrode active material, the conductive agent, and the binder in consideration of a coating thickness of a slurry and manufacturing yield, and may allow to have a viscosity that may provide excellent thickness uniformity during the subsequent coating for the preparation of the positive electrode.

Also, as another method, the positive electrode may be prepared by casting the composition for forming a positive electrode active material layer on a separate support and then laminating a film separated from the support on the positive electrode collector.

## Lithium Secondary Battery

According to another embodiment of the present invention, an electrochemical device including the positive electrode is provided. The electrochemical device may specifically be a battery or a capacitor, and may more specifically be a lithium secondary battery.

The lithium secondary battery specifically includes a positive electrode, a negative electrode disposed to face the positive electrode, a separator disposed between the positive electrode and the negative electrode, and an electrolyte, wherein the positive electrode is the same as described above. Also, the lithium secondary battery may further optionally include a battery container accommodating an electrode assembly of the positive electrode, the negative electrode, and the separator, and a sealing member sealing the battery container.

In the lithium secondary battery, the negative electrode includes a negative electrode collector and a negative electrode active material layer disposed on the negative electrode collector.

The negative electrode collector is not particularly limited as long as it has high conductivity without causing adverse chemical changes in the battery, and, for example, copper, stainless steel, aluminum, nickel, titanium, fired carbon, copper or stainless steel that is surface-treated with one of carbon, nickel, titanium, silver, or the like, and an aluminum-cadmium alloy may be used. Also, the negative electrode collector may typically have a thickness of 3 $\mu$m to 500 $\mu$m, and, similar to the positive electrode collector, microscopic irregularities may be formed on the surface of the collector to improve the adhesion of a negative electrode active material. The negative electrode collector, for example, may be used in various shapes such as that of a film, a sheet, a foil, a net, a porous body, a foam body, a non-woven fabric body, and the like.

The negative electrode active material layer optionally includes a binder and a conductive agent in addition to the negative electrode active material.

A compound capable of reversibly intercalating and deintercalating lithium may be used as the negative electrode active material. Specific examples of the negative electrode active material may be a carbonaceous material such as artificial graphite, natural graphite, graphitized carbon fibers, and amorphous carbon; a metallic compound alloyable with lithium such as silicon (Si), aluminum (Al), tin (Sn), lead (Pb), zinc (Zn), bismuth (Bi), indium (In), magnesium (Mg), gallium (Ga), cadmium (Cd), a Si alloy, a Sn alloy, or an Al alloy; a metal oxide which may be doped and undoped with lithium such as $SiO_x(O<x<2)$, $SnO_2$, vanadium oxide, and lithium vanadium oxide; or a composite including the metallic compound and the carbonaceous material such as a Si-C composite or a Sn-C composite, and any one thereof or a mixture of two or more thereof may be used. Also, a metallic lithium thin film may be used as the negative electrode active material. Furthermore, both low crystalline carbon and high crystalline carbon may be used as the carbon material. Typical examples of the low crystalline carbon may be soft carbon and hard carbon, and typical examples of the high crystalline carbon may be irregular, planar, flaky, spherical, or fibrous natural graphite or artificial graphite, Kish graphite, pyrolytic carbon, mesophase pitch-based carbon fibers, meso-carbon microbeads, mesophase pitches, and high-temperature sintered carbon such as petroleum or coal tar pitch derived cokes.

Also, the binder and the conductive agent may be the same as those previously described in the positive electrode.

As an example, the negative electrode active material layer may be prepared by applying a composition for forming a negative electrode active material layer, which is prepared by dissolving or dispersing optionally the binder and the conductive agent as well as the negative electrode active material in a solvent, onto the negative electrode collector and drying the coated negative electrode collector, or may be prepared by casting the composition for forming a negative electrode active material layer on a separate support and then laminating a film separated from the support on the negative electrode collector.

In the lithium secondary battery, the separator separates the negative electrode and the positive electrode and provides a movement path of lithium ions, wherein any separator may be used as the separator without particular limitation as long as it is typically used in a lithium secondary battery, and particularly, a separator having high moisture-retention ability for an electrolyte as well as low resistance to the transfer of electrolyte ions may be used. Specifically, a porous polymer film, for example, a porous polymer film prepared from a polyolefin-based polymer, such as an ethylene homopolymer, a propylene homopolymer, an ethylene/butene copolymer, an ethylene/hexene copolymer, and an ethylene/methacrylate copolymer, or a laminated structure having two or more layers thereof may be used. Also, a typical porous nonwoven fabric, for example, a nonwoven fabric formed of high melting point glass fibers or polyethylene terephthalate fibers may be used. Furthermore, a coated separator including a ceramic component or a polymer material may be used to secure heat resistance or mechanical strength, and the separator having a single layer or multilayer structure may be optionally used.

Also, the electrolyte used in the present invention may include an organic liquid electrolyte, an inorganic liquid electrolyte, a solid polymer electrolyte, a gel-type polymer electrolyte, a solid inorganic electrolyte, or a molten-type inorganic electrolyte which may be used in the preparation of the lithium secondary battery, but the present invention is not limited thereto.

Specifically, the electrolyte may include an organic solvent and a lithium salt.

Any organic solvent may be used as the organic solvent without particular limitation so long as it may function as a medium through which ions involved in an electrochemical reaction of the battery may move. Specifically, an ester-based solvent such as methyl acetate, ethyl acetate, $\gamma$-butyrolactone, and $\varepsilon$-caprolactone; an ether-based solvent such as dibutyl ether or tetrahydrofuran; a ketone-based solvent such as cyclohexanone; an aromatic hydrocarbon-based solvent such as benzene and fluorobenzene; or a carbonate-based solvent such as dimethyl carbonate (DMC), diethyl carbonate (DEC), ethylmethyl carbonate (EMC), ethylene carbonate (EC), and propylene carbonate (PC); an alcohol-based solvent such as ethyl alcohol and isopropyl alcohol; nitriles such as R-CN (where R is a linear, branched, or cyclic C2-C20 hydrocarbon group and may include a double-bond aromatic ring or ether bond); amides such as dimethylformamide; dioxolanes such as 1,3-dioxolane; or sulfolanes may be used as the organic solvent. Among these solvents, the carbonate-based solvent is preferable, and a mixture of a cyclic carbonate (e.g., ethylene carbonate or propylene carbonate) having high ionic conductivity and high dielectric constant, which may increase charge/discharge performance of the battery, and a low-viscosity linear carbonate-based compound (e.g., ethylmethyl carbonate, dimethyl carbonate, or diethyl carbonate) is more preferable. In this case, the performance of the electrolyte solution may be excellent when the cyclic carbonate and the chain carbonate are mixed in a volume ratio of about 1:1 to about 1:9.

The lithium salt may be used without particular limitation as long as it is a compound capable of providing lithium ions used in the lithium secondary battery. Specifically, $LiPF_6$, $LiClO_4$, $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, $LiCl$, $LiI$, or $LiB(C_2O_4)_2$ may be used as the lithium salt. The lithium salt may be used in a concentration range of 0.1 M to 2.0 M. In a case in which the concentration of the lithium salt is included within the above range, since the electrolyte may have appropriate conductivity and viscosity, excellent performance of the electrolyte may be obtained and lithium ions may effectively move.

In order to improve life characteristics of the battery, suppress the reduction in battery capacity, and improve discharge capacity of the battery, at least one additive, for example, a halo-alkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride, may be further included in the electrolyte in addition to the electrolyte components. In this case, the additive may be included in an amount of 0.1 wt% to 5 wt% based on a total weight of the electrolyte.

As described above, since the lithium secondary battery including the positive electrode active material according to the present invention stably exhibits excellent discharge capacity, output characteristics, and capacity retention, the lithium secondary battery is suitable for portable devices, such as mobile phones, notebook computers, and digital cameras, and electric cars such as hybrid electric vehicles (HEVs).

Thus, according to another embodiment of the present invention, a battery module including the lithium secondary battery as a unit cell and a battery pack including the battery module are provided.

The battery module or the battery pack may be used as a power source of at least one medium and large sized device of a power tool; electric cars including an electric vehicle (EV), a hybrid electric vehicle, and a plug-in hybrid electric vehicle (PHEV); or a power storage system.

A shape of the lithium secondary battery of the present invention is not particularly limited, but a cylindrical type using a can, a prismatic type, a pouch type, or a coin type may be used.

The lithium secondary battery according to the present invention may not only be used in a battery cell that is used as a power source of a small device, but may also be used as a unit cell in a medium and large sized battery module including a plurality of battery cells.

## MODE FOR CARRYING OUT THE INVENTION

### Examples

Hereinafter, examples of the present invention will be described in detail in such a manner that it may easily be carried out by a person with ordinary skill in the art to which the present invention pertains. The invention may, however, be embodied in many different forms and should not be construed as being limited to the examples set forth herein.

### Example 1

After a positive electrode active material precursor [composition: $Ni_{0.95}Co_{0.03}Mn_{0.02}(OH)_2$, average particle diameter ($D_{50}$) of 10.0 $\mu$m] and LiOH, as a lithium raw material, were mixed at a molar ratio of 1:1.05 and primarily sintered at a temperature of 850°C for 6 hours in an oxygen atmosphere to prepare a pre-sintered product, the pre-sintered product was ground to have an average particle diameter ($D_{50}$) of 5.0 $\mu$m and then secondarily sintered at a temperature of 750°C for 9 hours in an oxygen atmosphere to prepare a sintered product. Thereafter, the sintered product was mixed with 2 mol% $Co(OH)_2$ and heat-treated at a temperature of 700°C for 6 hours to prepare a lithium transition metal oxide in a form of a single particle.

### Example 2

After a positive electrode active material precursor [composition: $Ni_{0.86}Co_{0.05}Mn_{0.09}(OH)_2$, average particle diameter ($D_{50}$) of 10.0 $\mu$m] and LiOH, as a lithium raw material, were mixed at a molar ratio of 1:1.05 and primarily sintered at a temperature of 870°C for 6 hours in an oxygen atmosphere to prepare a pre-sintered product, the pre-sintered product was ground to have an average particle diameter ($D_{50}$) of 4.0 $\mu$m and then secondarily sintered at a temperature of 780°C for 9 hours in an oxygen atmosphere to prepare a sintered product. Thereafter, the sintered product was mixed with 2 mol% $Co(OH)_2$ and heat-treated at a temperature of 700°C for 6 hours to prepare a lithium transition metal oxide in a form of a single particle.

**Example 3**

After a positive electrode active material precursor [composition: $Ni_{0.83}Co_{0.05}Mn_{0.12}(OH)_2$, average particle diameter ($D_{50}$) of 10.0 $\mu$m] and LiOH, as a lithium raw material, were mixed at a molar ratio of 1:1.05 and primarily sintered at a temperature of 890°C for 6 hours in an oxygen atmosphere to prepare a pre-sintered product, the pre-sintered product was ground to have an average particle diameter ($D_{50}$) of 4.0 $\mu$m and then secondarily sintered at a temperature of 800°C for 9 hours in an oxygen atmosphere to prepare a sintered product. Thereafter, the sintered product was mixed with 2 mol% $Co(OH)_2$ and heat-treated at a temperature of 700°C for 6 hours to prepare a lithium transition metal oxide in a form of a single particle.

**Example 4**

After a positive electrode active material precursor [composition: $Ni_{0.6}Co_{0.1}Mn_{0.3}(OH)_2$, average particle diameter ($D_{50}$) of 4 $\mu$m] and LiOH, as a lithium raw material, were mixed at a molar ratio of 1:1.05 and primarily sintered at a temperature of 970°C for 9 hours in an oxygen atmosphere to prepare a pre-sintered product, the pre-sintered product was ground to have an average particle diameter ($D_{50}$) of 4 $\mu$m and then secondarily sintered at a temperature of 900°C for 9 hours in an oxygen atmosphere to prepare a sintered product. Thereafter, the sintered product was mixed with 3 mol% $Co(OH)_2$ and heat-treated at a temperature of 790°C for 6 hours to prepare a lithium transition metal oxide in a form of a single particle.

**Comparative Example 1**

After a positive electrode active material precursor [composition: $Ni_{0.95}Co_{0.03}Mn_{0.02}(OH)_2$, average particle diameter ($D_{50}$) of 5.0 $\mu$m] and LiOH, as a lithium raw material, were mixed at a molar ratio of 1:1.07 and primarily sintered at a temperature of 850°C for 6 hours in an oxygen atmosphere to prepare a pre-sintered product, the pre-sintered product was ground to have an average particle diameter ($D_{50}$) of 5.0 $\mu$m and then secondarily sintered at a temperature of 750°C for 9 hours in an oxygen atmosphere to prepare a sintered product. Thereafter, the sintered product was mixed with 2 mol% $Co(OH)_2$ and heat-treated at a temperature of 700°C for 6 hours to prepare a lithium transition metal oxide in a form of a single particle.

**Comparative Example 2**

After a positive electrode active material precursor [composition: $Ni_{0.89}Co_{0.05}Mn_{0.09}(OH)_2$, average particle diameter ($D_{50}$) of 4.0 $\mu$m] and LiOH, as a lithium raw material, were mixed at a molar ratio of 1:1.07 and primarily sintered at a temperature of 900°C for 9 hours in an oxygen atmosphere to prepare a pre-sintered product, the pre-sintered product was ground to have an average particle diameter ($D_{50}$) of 4.0 $\mu$m and then secondarily sintered at a temperature of 780°C for 9 hours in an oxygen atmosphere to prepare a sintered product. Thereafter, the sintered product was mixed with 2 mol% $Co(OH)_2$ and heat-treated at a temperature of 700°C for 6 hours to prepare a lithium transition metal oxide in a form of a single particle.

**Comparative Example 3**

After a positive electrode active material precursor [composition: $Ni_{0.83}Co_{0.05}Mn_{0.12}(OH)_2$, average particle diameter ($D_{50}$) of 6.0 $\mu$m] and LiOH, as a lithium raw material, were mixed at a molar ratio of 1:1.07 and primarily sintered at a temperature of 910°C for 9 hours in an oxygen atmosphere to prepare a pre-sintered product, the pre-sintered product was ground to have an average particle diameter ($D_{50}$) of 4.0 $\mu$m and then secondarily sintered at a temperature of 800°C for 9 hours in an oxygen atmosphere to prepare a sintered product. Thereafter, the sintered product was mixed with 2 mol% $Co(OH)_2$ and heat-treated at a temperature of 700°C for 6 hours to prepare a lithium transition metal oxide in a form of a single particle.

**Comparative Example 4**

After a positive electrode active material precursor [composition: $Ni_{0.95}Co_{0.03}Mn_{0.02}(OH)_2$, average particle diameter ($D_{50}$) of 5.0 $\mu$m] and LiOH, as a lithium raw material, were mixed at a molar ratio of 1:1.03 and primarily sintered at a temperature of 850°C for 6 hours in an oxygen atmosphere to prepare a pre-sintered product, the pre-sintered product was ground to have an average particle diameter ($D_{50}$) of 5.0 $\mu$m and then secondarily sintered at a temperature of 750°C for 9 hours in an oxygen atmosphere to prepare a lithium transition metal oxide in a form of a single particle.

**Comparative Example 5**

After a positive electrode active material precursor [composition: $Ni_{0.95}Co_{0.03}Mn_{0.02}(OH)_2$, average particle diameter ($D_{50}$) of 10.0 $\mu$m] and LiOH, as a lithium raw material, were mixed at a molar ratio of 1:1.03 and primarily sintered at a temperature of 830°C for 9 hours in an oxygen atmosphere to prepare a pre-sintered product, the pre-sintered product was ground to have an average particle diameter ($D_{50}$) of 5.0 $\mu$m and then secondarily sintered at a temperature of 750°C for 9 hours in an oxygen atmosphere to prepare a lithium transition metal oxide in a form of a single particle.

**Experimental Example 1: Analysis of Positive Electrode Active Materials**

Each of the powder-type positive electrode active materials in the form of a single particle, which were prepared in Examples 1 to 4 and Comparative Examples 1 to 5, was Ar-ion milled for 2 hours using an ion milling system (JBOL, IB19520CCP) (accelerating voltage: 6 kV) to prepare each cross-sectional sample.

1) An EBSD band contrast map was created for each cross-sectional sample of the powder-type positive electrode active material in the form of a single particle using a field emission scanning electron microscope (SEM, JEOL JSM-7900F w/Oxford symmetry EBSD detector) (accelerating voltage: 20 kV). AztecCrystal by OXFORD Instruments was used as an image processing-EBSD quantification analysis software.

2) A cross-section of the positive electrode was measured and analyzed for each cross-sectional sample of the powder-type positive electrode active material in the form of a single particle using the field emission scanning electron microscope (SEM, JEOL JSM-7900F w/Oxford symmetry EBSD detector) (accelerating voltage: 20 kV). An EBSD IPF map was created using the AztecCrystal by OXFORD Instruments as the image processing-EBSD quantification analysis software.

3) An SEM image was taken from a surface of the cross-sectional sample of the powder-type positive electrode active material in the form of a single particle using a scanning electron microscope (SEM, JEOL JSM-7900F).

**Experimental Example 2: Measurement of Boundary Length**

(1) Calculation of Length of Boundary using EBSD IPF Map

A boundary image was obtained by detecting a boundary using the EBSD IPF map and an image J program, and a length of the boundary, which was measured from the EBSD IPF map, was calculated.

(2) Calculation of Length of Boundary using EBSD Band Contrast Map

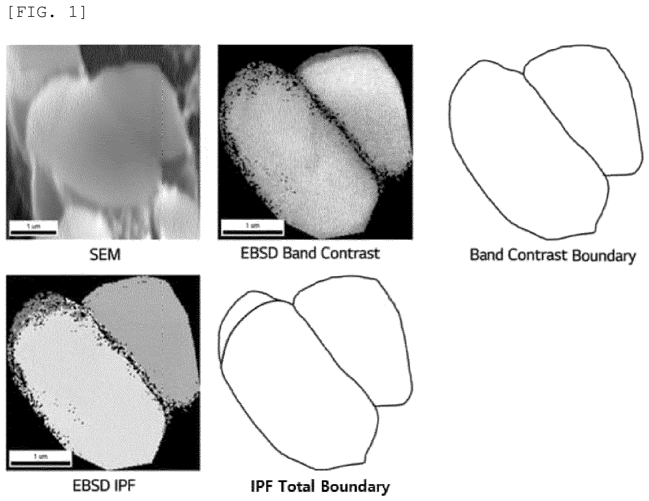

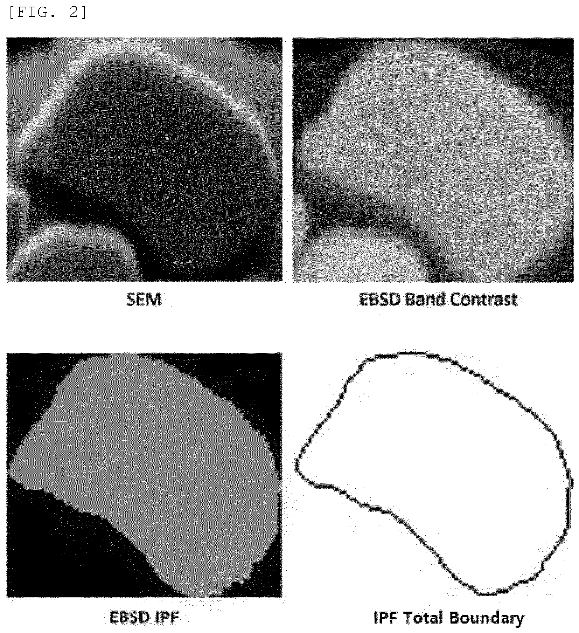

A length of a boundary was calculated in the same manner as in (1) above using the EBSD band contrast map.
(3) A boundary image was obtained by separating the inside and outside of the particle in the same manner as in (1) above using the SEM image and a length of an SEM outer boundary was calculated.
SEM images, EBSD band contrast maps, EBSD IPF maps, and IPF boundaries of the positive electrode active materials of Example 1 and Comparative Example 4 are illustrated in FIG. 1 and FIG. 2, respectively.
Referring to FIG. 1, with respect to the positive electrode active material of Example 1, a boundary formed inside the positive electrode active material particle, which was not observed in the SEM image of the positive electrode of Comparative Example 4, was observed in the EBSD BC map, and also, a boundary, which was not observed in the EBSD BC map, was additionally observed in the EBSD IPF map. As described above, the boundary, which was not observed in the SEM image, but was observed in the EBSD BC map, corresponded to a strong boundary which was formed by collapse of a layered structure of a NiO layer, and the boundary observed only in the EBSD IPF map corresponded to a weak boundary where only an atomic arrangement was simply different and crystallinity was not collapsed.
Referring to FIG. 2, with respect to the positive electrode active material of Comparative Example 4, a boundary inside the particle was not observed in all of the SEM image, the EBSD BC map, and the EBSD IPF map, and, accordingly, with respect to the positive electrode active material of Comparative Example 4, it may be confirmed that neither strong nor weak boundaries were formed inside the particle.

**Experimental Example 3: Electrochemical Property Evaluation**

**Preparation of Positive Electrode and Half-cell**

The positive electrode active material prepared in Example 1, carbon black (Denka Company Limited, Denka Black) as a conductive agent, and PVdF (Kureha Corporation, KF1300), as a binder, were added in a weight ratio of 97.5:1:1.5 (positive electrode active material:conductive agent:binder) to a solvent (DAEJUNG CHEMICALS & METALS CO., LTD., N-methylpyrrolidone (NMP)) to prepare a composition for forming a positive electrode active material layer.

One surface of a 12 μm thick aluminum foil current collector was coated with the above-prepared composition for forming a positive electrode active material layer and dried at 135°C for 3 hours to form a positive electrode active material layer. Subsequently, the positive electrode active material layer was rolled by a roll pressing method, and, after the rolling, a positive electrode having a porosity of the positive electrode active material layer of 24% was prepared.

Positive electrodes were prepared in the same manner as the above method by using the positive electrode active materials of Examples 2 to 4 and Comparative Examples 1 to 5, respectively, instead of the positive electrode active material prepared in Example 1.

A half-cell was prepared by using lithium metal, as a negative electrode, along with the above-prepared positive electrode.

**Electrochemical Property Evaluation Method**

Each of the above-prepared coin half-cells was charged at a constant current (CC) of 0.2 C to 4.25 V at 25°C and then charged at a constant voltage (CV) until the charging current was 0.05 C (cut-off current) to measure charge capacity. Thereafter, each coin half-cell was left standing for 20 minutes and then discharged at a constant current (CC) of 0.2 C to 2.5 V to measure discharge capacity in a 1$^{st}$ cycle.

The cell after completion of one cycle was transferred to a chamber at 45°C and was repeatedly charged and discharged at 0.33 C for up to 50 cycles, discharge capacity in a 50$^{th}$ cycle was measured, and capacity retention was evaluated by calculating the discharge capacity in the 50$^{th}$ cycle relative to the discharge capacity in the 1$^{st}$ cycle.

[Table 1]

|  | IPF boundary/ BC boundary | Inner boundary/ outer boundary | Charge capacity (mAh/g) | Discharge capacity (mAh/g) | 50 cycle lifetime (%) |
|---|---|---|---|---|---|
| Example 1 | 1.1 | 0.2 | 234.4 | 208.4 | 95.4 |
| Example 2 | 1.3 | 0.1 | 231.3 | 206.3 | 95.2 |
| Example 3 | 1.3 | 0.3 | 228.1 | 203.5 | 96.3 |
| Example 4 | 1.2 | 0.3 | 216.4 | 197.2 | 96.8 |
| Comparative Example 1 | 2.3 | 1.3 | 235.2 | 209.1 | 91.2 |
| Comparative Example 2 | 2.1 | 1 | 232.1 | 207.0 | 90.8 |
| Comparative Example 3 | 1.7 | 0.8 | 228.7 | 203.9 | 91.6 |
| Comparative Example 4 | 1.0 | 0 | 227.5 | 201.2 | 93.2 |
| Comparative Example 5 | 1.0 | 0 | 231.5 | 202.1 | 92.5 |

Referring to Table 1, it may be confirmed that the positive electrode active materials of Examples 1 to 4 exhibited improved life characteristics by exhibiting higher 50 cycle lifetimes than the positive electrode active materials of Comparative Examples 1 to 5.

**Claims**

1.  A positive electrode active material comprising a lithium transition metal oxide in a form of a single particle,

    wherein the lithium transition metal oxide in the form of a single particle comprises an outer boundary forming an outline of the particle and an inner boundary formed in the particle, and satisfies Equation 1, 0 < length of the inner boundary/length of the outer boundary < 0.4                    [Equation 1]

    The length of the inner boundary is a length obtained by subtracting a length of a boundary, which is measured from an EBSD band contrast map, from a length of a boundary which is measured from an electron backscatter diffraction (EBSD)-inverse pole figure (IPF) map of the lithium transition metal oxide particle, and the length of the outer boundary is a length of the outer boundary of the transition metal oxide particle which is measured by scanning electron microscope (SEM) image segmentation.

2. The positive electrode active material of claim 1, wherein the lithium transition metal oxide in the form of a single particle additionally satisfies Equation 2.

The length of the boundary which is measured from the EBSD IPF map/the length of the boundary which is measured from the EBSD band contrast map $\leq 1.4$ [Equation 2]

3. The positive electrode active material of claim 1, wherein the lithium transition metal oxide in the form of a single particle additionally satisfies Equation 3.

$0 \leq$ (the length of the inner boundary/the length of the outer boundary) - (the length of the inner boundary/the length of the boundary which is measured from the EBSD band contrast map) $\leq 1$ [Equation 3]

4. The positive electrode active material of claim 1, wherein the length of the boundary, which is measured from the electron backscatter diffraction (EBSD)-IPF map, comprises a length of a weak boundary, where an atomic arrangement is simply different and crystallinity is not collapsed, which is included in the lithium transition metal oxide particle in the form of a single particle, and a length of a strong boundary formed by collapse of a layered structure.

5. The positive electrode active material of claim 1, wherein the length of the boundary, which is measured by the EBSD band contrast map, comprises a length of a boundary formed by collapse of a layered structure which is included in the lithium transition metal oxide particle in the form of a single particle.

6. The positive electrode active material of claim 1, wherein the lithium transition metal oxide in the form of a single particle comprises 2 to 50 single crystal particles.

7. The positive electrode active material of claim 1, wherein the lithium transition metal oxide is a lithium composite transition metal oxide containing nickel, cobalt, and manganese.

8. The positive electrode active material of claim 1, wherein the lithium transition metal oxide is a lithium composite transition metal oxide represented by Formula 1:

[Formula 1] $\quad Li_aNi_bCo_cMn_dM^1_eO_2$

wherein, in Formula 1, $M^1$ is at least one selected from the group consisting of aluminum (Al), zirconium (Zr), boron (B), tungsten (W), molybdenum (Mo), chromium (Cr), niobium (Nb), magnesium (Mg), hafnium (Hf), tantalum (Ta), lanthanum (La), titanium (Ti), strontium (Sr), barium (Ba), cerium (Ce), tin (Sn), yttrium (Y), zinc (Zn), fluorine (F), phosphorus (P), and sulfur (S), and $0.9 \leq a \leq 1.1$, $0.6 \leq b < 1$, $0 < c < 0.4$, $0 < d < 0.4$, $0 \leq e < 0.1$, and $b+c+d+e=1$.

9. The positive electrode active material of claim 1, wherein the lithium transition metal oxide is a lithium composite transition metal oxide represented by Formula 2:

[Formula 2] $\quad Li_aNi_bCo_cMn_dO_2$

wherein, in Formula 2, $0.9 \leq a \leq 1.1$, $0.6 \leq b < 1$, $0 < c < 0.4$, $0 < d < 0.4$, and $b+c+d=1$.

10. The positive electrode active material of claim 1, further comprising a second lithium transition metal oxide in a form of a single particle, which has a smaller average particle diameter ($D_{50}$) than the lithium transition metal oxide in the form of a single particle, and having a bimodal particle size distribution.

11. The positive electrode active material of claim 10, wherein the second lithium transition metal oxide is a lithium composite transition metal oxide represented by Formula 3:

[Formula 3] $\quad Li_{a3}Ni_{b3}Co_{c3}Mn_{d3}M^3_{e3}O_2$

wherein, in Formula 3, $M^3$ is at least one selected from the group consisting of Al, Zr, B, W, Mo, Cr, Nb, Mg, Hf, Ta, La, Ti, Sr, Ba, Ce, Sn, Y, Zn, F, P, and S, and $0.9 \leq a3 \leq 1.1$, $0.6 \leq b3 < 1$, $0 < c3 < 0.4$, $0 < d3 < 0.4$, $0 \leq e3 < 0.1$, and $b3 + c3 + d3 + e3 = 1$.

12. The positive electrode active material of claim 10, wherein a weight ratio of the lithium transition metal oxide to the second lithium transition metal oxide is in a range of 1~9:1.

13. The positive electrode active material of claim 10, wherein press density is in a range of 3.50 g/cm$^2$ to 3.90 g/cm$^2$.

14. A positive electrode comprising the positive electrode active material of any one of claims 1 to 13.

15. A lithium secondary battery comprising the positive electrode of claim 14.

[FIG. 1]

SEM

EBSD Band Contrast

Band Contrast Boundary

EBSD IPF

IPF Total Boundary

[FIG. 2]

SEM

EBSD Band Contrast

EBSD IPF

IPF Total Boundary

## INTERNATIONAL SEARCH REPORT

| | International application No. |
|---|---|
| | **PCT/KR2024/007495** |

| A. | CLASSIFICATION OF SUBJECT MATTER |
|---|---|

**H01M 4/525**(2010.01)i; **C30B 29/22**(2006.01)i; **H01M 4/02**(2006.01)i

According to International Patent Classification (IPC) or to both national classification and IPC

| B. | FIELDS SEARCHED |
|---|---|

Minimum documentation searched (classification system followed by classification symbols)

H01M 4/525(2010.01); H01M 10/052(2010.01); H01M 4/13(2010.01); H01M 4/36(2006.01); H01M 4/485(2010.01); H01M 4/505(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 양극 (cathode), 단입자 (single particle, grain), 외부 경계면 (outer boundary surface), 내부 경계면 (inner boundary surface), 소성 (sintering)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2023-0054296 A (LG CHEM, LTD.) 24 April 2023 (2023-04-24)<br>See abstract; and paragraphs [0068]-[0089] and [0152]-[0154]. | 1-15 |
| A | KR 10-2022-0040889 A (SK ON CO., LTD.) 31 March 2022 (2022-03-31)<br>See abstract; claims 1-14; and figure 1. | 1-15 |
| A | HWANG, D.-Y. et al. Single-crystalline Ni-rich LiNi0.91Co0.06Mn0.03O2 cathode enables durable interfacial stability for high electrochemical performances. International Journal of Energy Research. 2022, vol. 46, pp. 2064-2072.<br>See abstract; and page 2065, experimental. | 1-15 |
| A | KR 10-2007-0097923 A (IUCF-HYU (INDUSTRY-UNIVERSITY COOPERATION FOUNDATION HANYANG UNIVERSITY)) 05 October 2007 (2007-10-05)<br>See abstract; and claims 1-15. | 1-15 |

☑ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **09 September 2024** | **09 September 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
|---|
| **PCT/KR2024/007495** |

**C. DOCUMENTS CONSIDERED TO BE RELEVANT**

| Category* | Citation of document, with indication, where appropriate, of the relevant passages | Relevant to claim No. |
|---|---|---|
| A | EP 4071846 A1 (CONTEMPORARY AMPEREX TECHNOLOGY CO., LIMITED) 12 October 2022 (2022-10-12)<br>  See abstract; and claims 1-14. | 1-15 |

Form PCT/ISA/210 (second sheet) (July 2022)

## INTERNATIONAL SEARCH REPORT
### Information on patent family members

International application No.

**PCT/KR2024/007495**

| Patent document cited in search report | | | Publication date (day/month/year) | Patent family member(s) | | | Publication date (day/month/year) |
|---|---|---|---|---|---|---|---|
| KR | 10-2023-0054296 | A | 24 April 2023 | CA | 3217171 | A1 | 20 April 2023 |
| | | | | CN | 117178386 | A | 05 December 2023 |
| | | | | EP | 4303959 | A1 | 10 January 2024 |
| | | | | JP | 2024-512946 | A | 21 March 2024 |
| | | | | US | 2024-0186504 | A1 | 06 June 2024 |
| | | | | WO | 2023-063778 | A1 | 20 April 2023 |
| KR | 10-2022-0040889 | A | 31 March 2022 | CN | 114256450 | A | 29 March 2022 |
| | | | | EP | 3974391 | A1 | 30 March 2022 |
| | | | | US | 11973179 | B2 | 30 April 2024 |
| | | | | US | 2022-0093962 | A1 | 24 March 2022 |
| KR | 10-2007-0097923 | A | 05 October 2007 | JP | 2009-525578 | A | 09 July 2009 |
| | | | | JP | 4756715 | B2 | 24 August 2011 |
| | | | | KR | 10-0822012 | B1 | 14 April 2008 |
| | | | | US | 10367197 | B2 | 30 July 2019 |
| | | | | US | 2009-0068561 | A1 | 12 March 2009 |
| | | | | US | 2015-0010824 | A1 | 08 January 2015 |
| | | | | US | 8865348 | B2 | 21 October 2014 |
| | | | | WO | 2007-114557 | A1 | 11 October 2007 |
| EP | 4071846 | A1 | 12 October 2022 | CN | 114556614 | A | 27 May 2022 |
| | | | | EP | 4071846 | A4 | 27 March 2024 |
| | | | | US | 11121362 | B2 | 14 September 2021 |
| | | | | US | 2021-0167366 | A1 | 03 June 2021 |
| | | | | WO | 2021-108945 | A1 | 10 June 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230071877
- KR 20190094529 A1